# EUROPEAN PATENT APPLICATION

(11) **EP 4 491 919 A1**
(43) Date of publication of application: **15.01.2025**
(21) Application number: 24184057.8
(22) Date of filing: 24.06.2024
(51) Int. Cl.: F16K 11/085, F16K 27/06, F01P 7/16, B60K 1/00

(54) **COOLING MODULE**

(30) Priority: 12.07.2023 JP 2023114654
(71) Applicant: Aisin Corporation, Aichi 448-8650 (JP)
(72) Inventor: ISHII, Masato, Kariya, 448-8650 (JP); YANO, Hideto, Kariya, 448-8650 (JP)
(74) Representative: Winter, Brandl - Partnerschaft mbB

(57) **Abstract**

A cooling module includes: a manifold (1) including therein a first flow path (L1) configured to allow a first fluid (F1) to flow therethrough and a second flow path (L2) configured to allow a second fluid (F2) to flow therethrough; and a valve (3) attached to the manifold and configured to control the flow of the first fluid and the second fluid. The manifold includes a pressure adjusting flow path (120) configured to adjust a pressure between the first flow path and the second flow path.

## Description

### TECHNICAL FIELD

This disclosure relates to a cooling module.

### BACKGROUND DISCUSSION

As a technique for cooling a motor, a battery, and the like provided in a vehicle such as an electric automatic vehicle, for example, JP 2022-545035A (Reference 1) discloses a thermal management system including a refrigerant loop system, a motor liquid cooling loop system, an air conditioner liquid cooling loop system, and a battery liquid cooling loop system. In the thermal management system disclosed in Reference 1, the motor liquid cooling loop system is provided with a multifunction valve including an expansion kettle.

In the thermal management system disclosed in Reference 1, the motor liquid cooling loop system is provided with the multifunction valve including the expansion kettle, while the battery liquid cooling loop system is not provided with the expansion kettle. Therefore, even in the case where the fluid flowing through the battery liquid cooling loop system thermally expands, the pressure cannot be adjusted (depressurized) on the battery liquid cooling loop system side. As a result, the flow rate of the pump provided on the battery liquid cooling loop system side may be unstable, and the cooling capacity on the battery liquid cooling loop system side may decrease.

A need thus exists for a cooling module in which a pressure in a flow path through which a fluid flows can be adjusted.

### SUMMARY

According to an aspect of this disclosure, a cooling module includes: a manifold including therein a first flow path configured to allow a first fluid to flow therethrough and a second flow path configured to allow a second fluid to flow therethrough; and a valve attached to the manifold and configured to control the flow of the first fluid and the second fluid. The manifold includes a pressure adjusting flow path configured to adjust a pressure between the first flow path and the second flow path.

According to such a characteristic configuration, the pressure adjusting flow path for adjusting the pressure balance is provided in the manifold, and therefore, the pressure between the first flow path and the second flow path can be adjusted (reduced). In addition, the pressure adjusting flow path is provided in the manifold, and therefore, the drawing amount of pipes can be reduced as compared with a case where a separate pressure adjusting flow path is provided outside the cooling module.

### BRIEF DESCRIPTION OF THE DRAWINGS

The foregoing and additional features and characteristics of this disclosure will become more apparent from the following detailed description considered with the reference to the accompanying drawings, wherein:
FIG. 1 is a circuit configuration diagram illustrating a part of a cooling system including a cooling module according to an embodiment;
FIG. 2 is an exploded perspective view illustrating a configuration of the cooling module according to the embodiment;
FIG. 3 is an exploded perspective cross-sectional view illustrating a manifold according to the embodiment;
FIG. 4 is a plan view illustrating a second wall portion according to the embodiment;
FIG. 5 is a view illustrating a configuration of a valve according to the embodiment;
FIG. 6 is a cross-sectional view taken along a line VI-VI shown in FIG. 5; and
FIG. 7 is a cross-sectional view illustrating a part of the valve and the manifold according to the embodiment.

### DETAILED DESCRIPTION

Hereinafter, embodiments of a cooling module according to this disclosure will be described with reference to the drawings. However, this disclosure is not limited to the following embodiments, and various modifications can be made without departing from the gist of this disclosure.

### Cooling System

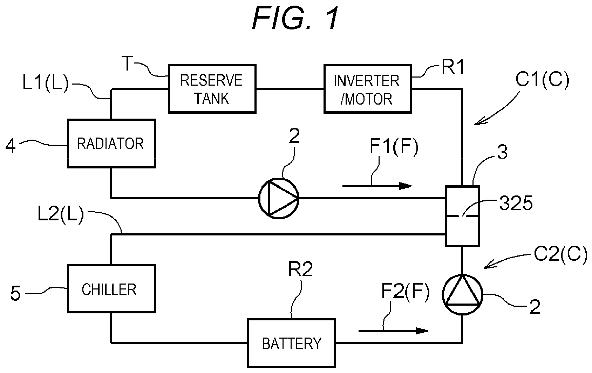

First, a configuration of a cooling system A including a cooling module 100 will be described with reference to FIG. 1. FIG. 1 is a circuit configuration diagram illustrating a part of the cooling system A including the cooling module 100. The cooling system A is a system that is mounted on an electric vehicle (hereinafter, referred to as an "electric vehicle") traveling by electric power and cools a cooling target device (an inverter/motor R1, a battery R2, and the like) mounted on the electric vehicle. The inverter/motor R1 is a traveling drive source that operates by being supplied with electric power, and the battery R2 stores electric power and supplies the electric power to the inverter/motor R1 as necessary. Examples of the electric vehicle include a hybrid electric vehicle (HEV), a plug-in hybrid electric vehicle (PHEV), a battery electric vehicle (BEV), and a fuel cell electric vehicle (FCEV).

As illustrated in FIG. 1, the cooling system A includes pumps 2, a valve 3, a radiator 4, a chiller 5, and a fluid flow path L through which a fluid F flows. The fluid F is a cooling fluid such as a long life coolant (LLC). In this case, the fluid F is not limited to a cooling fluid such as a long life coolant (LLC), and may be a refrigerant such as an insulating oil, for example, a paraffin-based oil, a hydrofluorocarbon (HFC), and a hydrofluoroolefin (HFO).

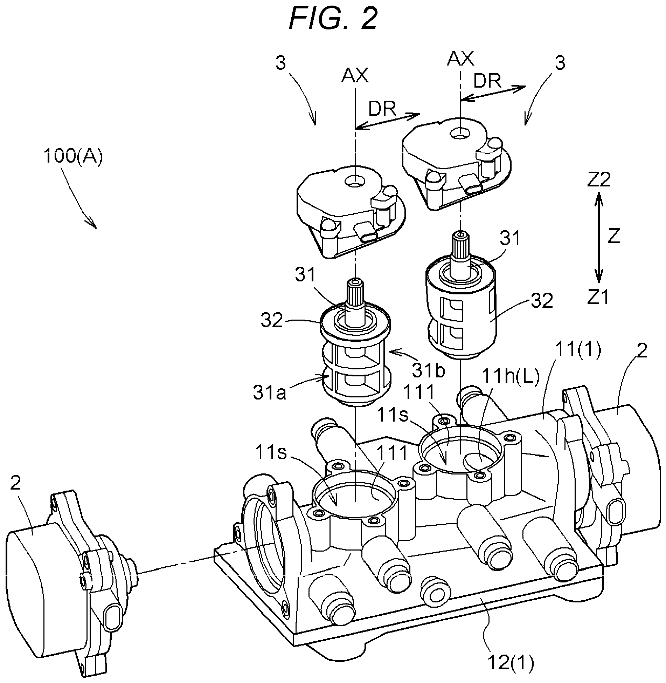

The pump 2 pressure-feeds the fluid F to cause the fluid F to flow in the fluid flow path L. The pump 2 is, for example, an electric water pump. The valve 3 controls the flow of the fluid F. The valve 3 is a rotary valve that includes a rotation shaft 31 and a valve body 32 rotating about the rotation shaft 31 (see FIG. 2) and rotates about an axis AX of the rotation shaft 31. The radiator 4 and the chiller 5 adjust a temperature of the fluid F (for example, cool the fluid F when the temperature of the fluid F is equal to or higher than a specified temperature).

The pumps 2, the valve 3, the radiator 4, the chiller 5, the inverter/motor R1, and the battery R2 are connected via the fluid flow path L. Accordingly, a circulation circuit C in which the fluid F circulates is formed. The circulation circuit C includes a first circulation circuit C1 through which the fluid F for adjusting (lowering) the temperature of the inverter/motor R1 circulates, and a second circulation circuit C2 through which the fluid F for adjusting (lowering) the temperature of the battery R2 circulates. Hereinafter, the fluid F circulating through the first circulation circuit C1 is referred to as a "first fluid F1", and the fluid flow path L forming the first circulation circuit C1 is referred to as a "first flow path L1". Further, the fluid F circulating through the second circulation circuit C2 is referred to as a "second fluid F2", and the fluid flow path L forming the second circulation circuit C2 is referred to as a "second flow path L2".

In the present embodiment, the cooling system A includes two pumps 2 and two valves 3. Each of the two valves 3 is a two-stage rotary valve in which two valve spaces (spaces through which the fluid F flows) are provided along a direction in which the axis AX of the rotation shaft 31 extends (hereinafter, referred to as an "axial direction"). For example, the valve 3 is a multiway valve such as a three-way valve that can switch a flow direction of the fluid F in three directions or a four-way valve that can switch the flow direction of the fluid F in four directions. The circulation circuit C described with reference to FIG. 1 shows an example of the circulation circuit C to which one of the two pumps 2 is connected. The first fluid F1 flowing through the first circulation circuit C1 and the second fluid F2 flowing through the second circulation circuit C2 flow through one of the two pumps 2. The first fluid F1 and the second fluid F2 may also flow through the other pump 2 of the two pumps 2.

The cooling system A further includes a reserve tank T that can absorb thermal expansion of the fluid F. In the present embodiment, the reserve tank T is provided only in the first circulation circuit C1 (the reserve tank that can absorb the thermal expansion of the fluid F is not provided in the second circulation circuit C2).

### Cooling Module

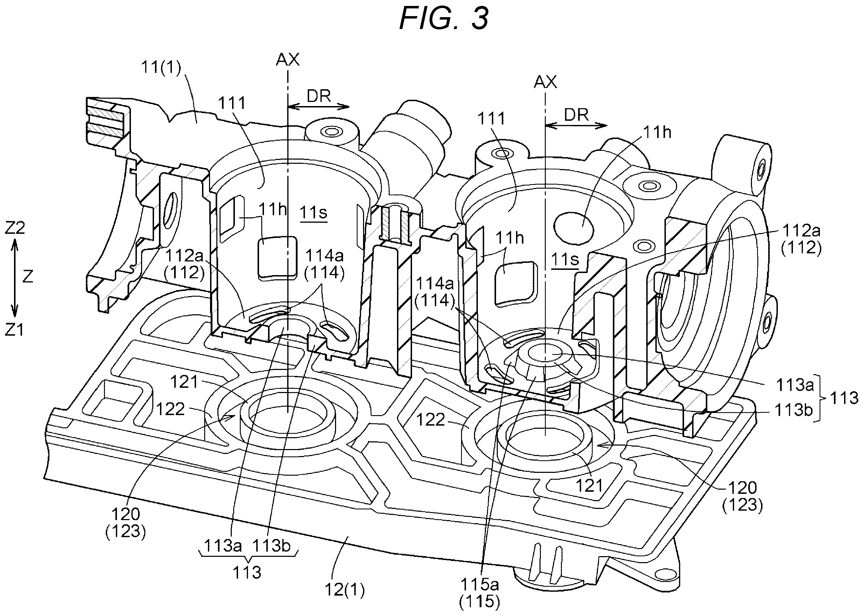

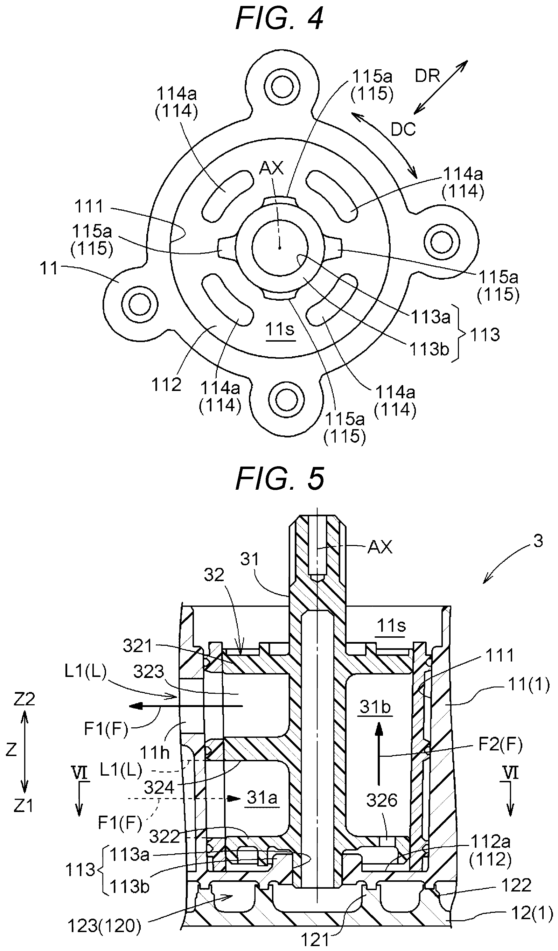

Next, a configuration of the cooling module 100 will be described with reference to FIGS. 2 to 4. FIG. 2 is an exploded perspective view illustrating a configuration of the cooling module 100. FIG. 3 is an exploded perspective cross-sectional view illustrating a manifold 1. In FIG. 3, a first housing 11 is cut along a Z direction. FIG. 4 is a view illustrating a second wall portion 112 of the manifold 1 when viewed along a Z1 direction.

As illustrated in FIG. 2, the cooling system A further includes the manifold 1 including a part of the fluid flow path L (the first flow path L1 and the second flow path L2 described with reference to FIG. 1) therein. The pumps 2 and the valves 3 are attached to the manifold 1, and the pumps 2, the valves 3, and the manifold 1 are integrated to form the cooling module 100. In the present embodiment, the cooling module 100 is formed by attaching two pumps 2 and two valves 3 to the manifold 1 (integration).

### Manifold

The manifold 1 has a box shape and includes the first housing 11 and a second housing 12. Hereinafter, a direction towards the second housing 12 when viewed from the first housing 11 is referred to as the "Z1 direction", a direction opposite thereto is referred to as a "Z2 direction", and the Z1 direction and the Z2 direction are collectively referred to as the "Z direction".

The first housing 11 and the second housing 12 are made of, for example, a resin. The manifold 1 is formed by joining and integrating the first housing 11 and the second housing 12 by welding or the like. A part of the fluid flow path L is provided inside the manifold 1 by a groove formed in at least one of the first housing 11 and the second housing 12.

### First Housing

As shown in FIGS. 2 and 3, the first housing 11 has accommodation spaces 11s (two accommodation spaces 11s in the present embodiment) that each accommodate a part (valve body 32) of the valve 3. The first housing 11 includes, as walls forming the accommodation space 11s, a cylindrical first wall portion 111 facing the valve 3 (valve body 32) in a radial direction of the valve 3 (hereinafter referred to as a "radial direction DR"), and the disk-shaped second wall portion 112 (see FIGS. 3 and 4) provided on a side close to the second housing 12 (in the Z1 direction when viewed from the valve 3 accommodated in the accommodation space 11s).

As shown in FIG. 3, the first wall portion 111 has a plurality of openings 11h. Each of the openings 11h allows the fluid flow path L (see FIG. 1) to communicate with the accommodation space 11s.

As shown in FIG. 4, the second wall portion 112 includes an insertion hole portion 113, a hole portion 114, and a rib portion 115.

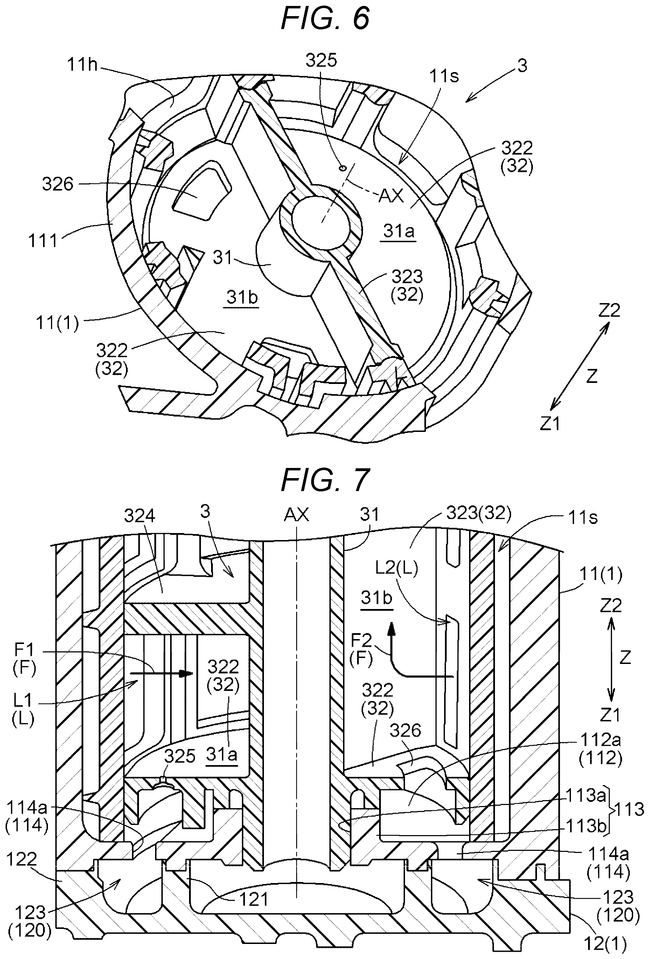

The insertion hole portion 113 has a circular shape when viewed along the Z direction, and includes an insertion hole 113a through which the rotation shaft 31 (see FIG. 7) of the valve 3 is inserted, and a peripheral edge portion 113b provided in an annular shape so as to surround the insertion hole 113a. The peripheral edge portion 113b protrudes from an opposing surface 112a in the Z2 direction (see FIG. 3). The opposing surface 112a is a plane of the second wall portion 112 facing the valve 3 (plane of the second wall portion 112 in the Z2 direction).

The hole portion 114 is provided outside the peripheral edge portion 113b (separated from the peripheral edge portion 113b) in the radial direction DR. The hole portion 114 includes a plurality of (four in the present embodiment) holes 114a, and the four holes 114a are formed in the second wall portion 112. A longitudinal direction of each of the holes 114a is a circumferential direction of the valve 3 (hereinafter, referred to as a "circumferential direction DC"). Therefore, hereinafter, the hole 114a is referred to as an "elongated hole 114a". Each of the insertion holes 113a and the elongated holes 114a penetrates the second wall portion 112 in the Z direction (see FIG. 3).

As illustrated in FIG. 4, the four elongated holes 114a are provided at equal intervals along the circumferential direction DC. Specifically, the four elongated holes 114a are provided at intervals of a central angle of 90 degrees around the insertion hole 113a when viewed along the Z direction.

As illustrated in FIG. 3, the rib portion 115 includes a plurality of ribs 115a protruding from the opposing surface 112a in the Z2 direction (direction toward the valve 3). In the present embodiment, as illustrated in FIG. 4, the rib portion 115 includes four ribs 115a, and the four ribs 115a are provided at equal intervals. Specifically, the four ribs 115a are provided at intervals of 90 degrees when viewed along the Z direction. That is, the four ribs 115a are provided radially around the insertion hole portion 113.

Each of the ribs 115a extends in a direction perpendicular to the Z direction (the radial direction DR). Each of the ribs 115a extends such that the peripheral edge portion 113b surrounding the insertion hole portion 113 serves as one end and an inner side in the radial direction DR relative to an inner edge of the elongated hole 114a serves as the other end. The four ribs 115a do not face any of the four elongated holes 114a in the radial direction DR, and when viewed along the radial direction DR, each rib 115a is provided between the elongated holes 114a adjacent to each other in the circumferential direction DC.

### Second Housing

As illustrated in FIG. 3, the second housing 12 has a pressure adjusting flow path 120. The pressure adjusting flow path 120 is a flow path for adjusting (reducing) a pressure between the first flow path L1 and the second flow path L2 described with reference to FIG. 1.

The pressure adjusting flow path 120 includes an annular groove 123 formed in the second housing 12. The annular groove 123 has an annular shape around the axis AX of the rotation shaft 31 and is formed between a first erected wall 121 and a second erected wall 122 of the second housing 12. Each of the first erected wall 121 and the second erected wall 122 has an annular shape provided around the axis AX of the rotation shaft 31 when viewed along the Z direction, and is erected toward the first housing 11. The second erected wall 122 is provided outside the first erected wall 121 in the radial direction DR such that a center of the second erected wall 122 coincides with a center of the first erected wall 121.

As shown in FIG. 7, the annular groove 123 faces the hole portion 114 provided in the second wall portion 112 in the Z direction, and faces the valve 3 accommodated in the accommodation space 11s.

### Valve

Next, a configuration of the valve 3 will be described with reference to FIGS. 5 to 7. Hereinafter, one of the two valves 3 illustrated in FIG. 2 will be described as an example. FIG. 5 is a view illustrating a configuration of the valve 3. FIG. 6 is a cross-sectional view taken along a line VI-VI shown in FIG. 5, and FIG. 7 is a cross-sectional view illustrating a part of the valve 3 and the manifold 1 (the configuration of the pressure adjusting flow path 120).

As described above, the valve 3 includes the rotation shaft 31 and the valve body 32 that is rotatable integrally with the rotation shaft 31 (see FIG. 5). The rotation shaft 31 extends along the Z direction and rotates when receiving power from a drive source such as an actuator.

As illustrated in FIG. 5, the valve body 32 includes a circular first valve wall 321 and a circular second valve wall 322 that are spaced apart from each other in an extending direction (Z direction) of the rotation shaft 31.

The second valve wall 322 faces the annular groove 123 in the Z direction via the second wall portion 112 in a state where the valve 3 is accommodated in the accommodation space 11s.

The valve body 32 of the valve 3 further includes a connection wall 323 provided to connect the first valve wall 321 and the second valve wall 322, and a semicircular (a semicircular shape as viewed in the Z direction) partition wall 324 extending in a direction perpendicular to the connection wall 323.

The valve 3 includes a first valve space 31a (an example of a first space) through which the first fluid F1 flows and a second valve space 31b (an example of a second space) through which the second fluid F2 flows. That is, the fluid F (the first fluid F1 and the second fluid F2) flowing through the different circulation circuits C (the first circulation circuit C1 and the second circulation circuit C2) described with reference to FIG. 1 flows through the first valve space 31a and the second valve space 31b. In the present embodiment, the first valve space 31a is partitioned by the connection wall 323, the partition wall 324, and the second valve wall 322. The second valve space 31b is partitioned by the first valve wall 321, the connection wall 323, and the second valve wall 322. Similarly, the other of the valves 3 illustrated in FIG. 2 may include at least the first valve wall 321, the second valve wall 322, and the connection wall 323, and may include at least a valve space (an example of a first space) through which the first fluid F1 flows and a valve space (an example of a second space) through which the second fluid F2 flows. In this case, the number and shape of the valve spaces are appropriately changed in accordance with the circulation circuit C to which the valve 3 is connected.

As shown in FIGS. 6 and 7, a first valve body hole 325 and a second valve body hole 326 are formed in the second valve wall 322 of the valve 3. The first valve body hole 325 and the second valve body hole 326 penetrate the second valve wall 322 along the Z direction. In the present embodiment, when viewed along the Z direction, the first valve body hole 325 is circular, and the second valve body hole 326 is fan-shaped.

As shown in FIG. 7, the first valve body hole 325 allows the first valve space 31a and the pressure adjusting flow path 120 to communicate with each other via the hole portion 114 (the elongated hole 114a). That is, the first flow path L1 communicates with the pressure adjusting flow path 120 via the first valve space 31a, the first valve body hole 325, and the hole portion 114 (the elongated hole 114a). The first valve body hole 325 reduces a flow rate of the fluid F flowing from the first valve space 31a into the pressure adjusting flow path 120. Specifically, the first valve body hole 325 is an orifice having a small flow path cross-sectional area on a first valve space 31a side. The flow path cross-sectional area refers to an area of the first valve body hole 325 in a direction perpendicular to the flow direction of a main flow of the fluid F flowing through the first valve body hole 325.

The second valve body hole 326 allows the second valve space 31b and the pressure adjusting flow path 120 to communicate with each other via the hole portion 114 (the elongated hole 114a). That is, the second flow path L2 communicates with the pressure adjusting flow path 120 via the second valve space 31b, the second valve body hole 326, and the hole portion 114 (the elongated hole 114a).

That is, the first flow path L1 and the second flow path L2 communicate with each other via the first valve space 31a, the first valve body hole 325, the hole portion 114, the second valve space 31b, the second valve body hole 326, and the pressure adjusting flow path 120.

According to the above-described configuration, the first flow path L1 and the second flow path L2 communicate with each other via the first valve space 31a, the first valve body hole 325, the hole portion 114, the second valve space 31b, the second valve body hole 326, and the pressure adjusting flow path 120. Therefore, for example, in the case where the first fluid F1 flowing through the first flow path L1 thermally expands and a pressure in the first flow path L1 is higher than a pressure in the second flow path L2, the pressure in the first flow path L1 can be released to the second flow path L2. Similarly, in the case where the second fluid F2 flowing through the second flow path L2 thermally expands and the pressure in the second flow path L2 is higher than the pressure in the first flow path L1, the pressure in the second flow path L2 can be released to the first flow path L1. That is, the pressure in the fluid flow path L (the first flow path L1 and the second flow path L2) can be adjusted (the pressure in the first flow path L1 and the second flow path L2 can be balanced).

As described with reference to FIG. 1, the reserve tank T is provided in the first circulation circuit C1. Therefore, the thermal expansion of the second fluid F2 flowing through the second flow path L2 can also be absorbed by the reserve tank T provided in the first circulation circuit C1 by allowing the first flow path L1 and the second flow path L2 to communicate with each other via the pressure adjusting flow path 120.

### Overview of Above-described Embodiment

In the above-described embodiment, the following configurations are considered.
(1) A cooling module 100 includes: a manifold 1 including therein a first flow path L1 configured to allow a first fluid F1 to flow therethrough and a second flow path L2 configured to allow a second fluid F2 to flow therethrough; and a valve 3 attached to the manifold 1 and configured to control the flow of the first fluid F1 and the second fluid F2. The manifold 1 includes a pressure adjusting flow path 120 configured to adjust a pressure between the first flow path L1 and the second flow path L2.
   According to this configuration, the pressure in a fluid flow path L (the first flow path L1 and the second flow path L2) can be adjusted (the pressure in the first flow path L1 and the second flow path L2 can be balanced). In addition, the pressure adjusting flow path 120 is provided in the manifold 1, and therefore, the drawing amount of pipes can be reduced as compared with a case where a separate pressure adjusting flow path is provided outside the cooling module 100.
(2) In the cooling module 100 according to (1), it is preferable that the valve 3 includes a rotation shaft 31 and a valve body 32 rotatable around the rotation shaft 31, an annular groove 123 having an annular shape around the rotation shaft 31 is formed in the manifold 1 to face the valve body 32 in a direction along the rotation shaft 31, and the pressure adjusting flow path 120 includes the annular groove 123.
   According to this configuration, the pressure adjusting flow path 120 includes the annular groove 123 having an annular shape around the rotation shaft 31. Therefore, even in the case where the valve 3 rotates, the first flow path L1 and the second flow path L2 can communicate with each other via the pressure adjusting flow path 120.
(3) In the cooling module 100 according to (2), it is preferable that a first valve body hole 325 and a second valve body hole 326 that penetrate the valve body 32 in a direction along the rotation shaft 31 are formed in the valve 3, a plurality of elongated holes 114a whose longitudinal direction is a direction in which the annular groove 123 extends are formed in the manifold 1, the first flow path L1 communicates with the pressure adjusting flow path 120 via the first valve body hole 325 and an elongated hole 114a, and the second flow path L2 communicates with the pressure adjusting flow path 120 via the second valve body hole 326 and an elongated hole 114a.
   According to this configuration, the first flow path L1 and the second flow path L2 communicate with each other via the first valve body hole 325 and the second valve body hole 326 formed in the valve 3 and the elongated hole 114a formed in the manifold 1, the pressure in the fluid flow path L can be adjusted.
(4) In the cooling module 100 according to (2) or (3), it is preferable that the manifold 1 further includes an insertion hole portion 113 through which the rotation shaft 31 is inserted, and a plurality of ribs 115a each extending in a direction perpendicular to the direction along the rotation shaft 31, and the plurality of ribs 115a are provided radially around the insertion hole portion 113.

According to this configuration, with the plurality of ribs 115a each extending in the direction perpendicular to the direction along the rotation shaft 31, the rigidity of the insertion hole portion 113 through which the rotation shaft 31 is inserted is improved, and the rotation shaft 31 can be stably supported. Accordingly, the valve 3 can rotate more stably.

### Other Embodiments

Next, other embodiments of the cooling module will be described.
(a) The pressure adjusting flow path 120 faces the valve 3 in the Z direction in the above embodiment, and the pressure adjusting flow path 120 may face the valve 3 in the radial direction DR.
(b) In the cooling module 100, the number of pumps 2 integrated with the manifold 1 is not particularly limited. The number of the valves 3 integrated with the manifold 1 is not particularly limited.
(c) The reserve tank T may be provided only in the second circulation circuit C2 instead of the first circulation circuit C1.
(d) The first valve body hole 325 and the second valve body hole 326 may be formed in one of the two valves 3 or both of the two valves 3, and the first flow path L1 and the second flow path L2 may communicate with each other via the first valve space 31a, the first valve body hole 325, the hole portion 114, the second valve body hole 326, the second valve space 31b, and the pressure adjusting flow path 120.
(e) The positions of the second valve wall 322 where the first valve body hole 325 and the second valve body hole 326 are provided can be interchanged. Specifically, the first valve body hole 325 is provided on the side of the second valve wall 322 that partitions the first valve space 31a (that is, the first flow path L1 side) in the above-described embodiment, and may be provided on the second valve space 31b side of the second valve wall 322 (that is, the second flow path L2 side). In this case, the second valve body hole 326 is provided on the side of the second valve wall 322 that partitions the first valve space 31a (that is, the first flow path L1 side).
(f) The case where the plurality of ribs 115a are provided radially around the insertion hole portion 113 has been described as an example in the above embodiment, and the plurality of ribs 115a are not provided radially. Therefore, the number of the ribs 115a is not limited to four. The number of the ribs 115a may be any number as long as the rigidity of the peripheral edge portion 113b is maintained and the stable rotation of the valve body 32 of the valve 3 is not hindered, and may be, for example, 2 to 3, or 5 or more.
(g) The case where the number of the elongated holes 114a of the hole portion 114 is four has been described in the above-described embodiment, and the number of the elongated holes 114a of the hole portion 114 is not limited to four, and may be two, three, or five or more. The shape of the hole (formed in the second housing 12) of the hole portion 114 is not limited to the elongated hole whose longitudinal direction is the circumferential direction DC. The hole formed in the second housing 12 may have a circular shape, an elliptical shape, a fan shape, or the like when viewed along the Z direction as long as the first flow path L1 and the second flow path L2 can communicate with each other via the pressure adjusting flow path 120.
(h) The first valve body hole 325 does not need to have a small flow path cross-sectional area on the first valve space 31a side so as to reduce the flow rate of the fluid F. The shape of the first valve body hole 325 as viewed along the Z direction is not limited to a circular shape, and may be a shape other than the circular shape, such as an elliptical shape, a triangular shape, or a rectangular shape. Similarly, the shape of the second valve body hole 326 as viewed along the Z direction is not limited to a fan shape, and may be a shape other than the fan shape, such as an elliptical shape, a triangular shape, or a rectangular shape.
(i) The auxiliary devices connected to the fluid flow path L is not limited to the above-described embodiment. For example, a DC-DC converter, a charger, or the like may also be connected to the fluid flow path L.
(j) The principles, preferred embodiment and mode of operation of the present invention have been described in the foregoing specification. However, the invention which is intended to be protected is not to be construed as limited to the particular embodiments disclosed. Further, the embodiments described herein are to be regarded as illustrative rather than restrictive. Variations and changes may be made by others, and equivalents employed, without departing from the spirit of the present invention. Accordingly, it is expressly intended that all such variations, changes and equivalents which fall within the spirit and scope of the present invention as defined in the claims, be embraced thereby.

### Industrial Applicability

The technique according to the present disclosure can be used for a cooling module.

## Claims

1. A cooling module (100) comprising:
a manifold (1) including therein a first flow path (L1) configured to allow a first fluid (F1) to flow therethrough and a second flow path (L2) configured to allow a second fluid (F2) to flow therethrough; and
a valve (3) attached to the manifold and configured to control the flow of the first fluid and the second fluid, wherein
the manifold includes a pressure adjusting flow path (120) configured to adjust a pressure between the first flow path and the second flow path.

2. The cooling module according to claim 1, wherein
the valve includes a rotation shaft (31) and a valve body (32) rotatable around the rotation shaft,
an annular groove (123) having an annular shape around the rotation shaft is formed in the manifold to face the valve body in a direction along the rotation shaft, and
the pressure adjusting flow path includes the annular groove.

3. The cooling module according to claim 2, wherein
a first valve body hole (325) and a second valve body hole (326) that penetrate the valve body in the direction along the rotation shaft are formed in the valve,
a plurality of elongated holes (114a) whose longitudinal direction is a direction in which the annular groove extends are formed in the manifold,
the first flow path communicates with the pressure adjusting flow path via the first valve body hole and the elongated holes, and
the second flow path communicates with the pressure adjusting flow path via the second valve body hole and the elongated holes.

4. The cooling module according to claim 2 or 3, wherein
the manifold further includes
an insertion hole portion (113) through which the rotation shaft is inserted, and
a plurality of ribs (115a) each extending in a direction perpendicular to the direction along the rotation shaft, and
the plurality of ribs are provided radially around the insertion hole portion.
